Europäisches Patentamt

European Patent Office

Office européen des brevets

(11) Veröffentlichungsnummer: **0 088 415**
A2

(12) # EUROPÄISCHE PATENTANMELDUNG

(21) Anmeldenummer: 83102192.8

(22) Anmeldetag: 05.03.83

(51) Int. Cl.³: **H 05 K 3/02, B 32 B 31/28**

(30) Priorität: 05.03.82 DE 3207911

(43) Veröffentlichungstag der Anmeldung: **14.09.83**
Patentblatt 83/37

(84) Benannte Vertragsstaaten: **AT BE CH FR GB IT LI LU NL SE**

(71) Anmelder: **Schmoock, Helmuth, Büchener Weg 121, D-2058 Lauenburg/Elbe (DE)**

(72) Erfinder: **Schmoock, Helmuth, Büchener Weg 121, D-2058 Lauenburg/Elbe (DE)**

(74) Vertreter: **Heldt, Gert, Dr. Dipl.-Ing., Neuer Wall 57 IV, D-2000 Hamburg 36 (DE)**

(54) Schichtstoff und Verfahren zur Herstellung von Leiterbahnen.

(57) Ein Schichtstoff zur Herstellung von Leiterbahnen besteht aus mindestens vier Schichten. Eine dieser Schichten ist eine Metallschicht, auf der die Leiterbahnen aufgebaut werden. Eine andere Schicht wird von einer nicht leitenden Platte gebildet, auf der die Metallschicht über einen eine weitere Schicht bildenden Haftvermittler haftet. Die vierte Schicht stellt eine die Metallschicht auf ihrer der leitenden Platte abgewandten Seite abdeckende Folie dar. Mindestens eine der Schichten weist unter dem Einfluß von Strahlen ein veränderliches Haftvermögen auf. Bei dem Verfahren zur Herstellung von Leiterbahnen ist vorgesehen, daß mindestens eine der Schichten aus einem strahlungsempfindlichen Material hergestellt wird. Nicht zu bestrahlende Teile der strahlungsempfindlichen Schicht werden mit einer die Leiterbahnen aufweisenden Schablone abgedeckt. Die nicht abgedeckten Teile werden bestrahlt. Die bestrahlten Teile der strahlungsempfindlichen Schicht werden von den unbestrahlten Teilen getrennt und dabei Teile der Metallschicht freigelegt. Diese Teile der Metallschicht werden in einem Metallisierungsbad verstärkt.

0088415

Die Erfindung betrifft einen Schichtstoff zur Herstellung von Leiterbahnen, der aus mindestens 4 Schichten besteht, von denen eine eine Metallschicht ist, auf der die Leiterbahnen aufgebaut werden, von denen eine andere eine nichtleitende Platte ist, auf der die Metallschicht einerseits über einen eine weitere Schicht bildenden Haftvermittler haftet, und deren letzte eine die Metallschicht andererseits abdeckende Folie ist.

Darüber hinaus betrifft die Erfindung ein Verfahren zur Herstellung von Leiterbahnen auf nichtleitenden Platten aus einem Schichtstoff, der aus mindestens 4 Schichten besteht, von denen eine eine Metallschicht ist, auf der die Leiterbahnen aufgebaut werden, von denen eine andere eine nichtleitende Platte ist, auf der die Metallschicht einerseits über einen eine weitere Schicht bildenden Haftvermittler haftet und deren letzte eine die Metallschicht andererseits abdeckende Folie ist.

Derartige Schaltungen sind im Verlaufe ihrer Erprobung zur Serienreife entwickelt worden und erzielen gute Erfolge bei einschlägigen Anwendern. Bei der Herstellung dieser Schaltungen muß insoweit sehr sorgfältig verfahren werden, als beim Aufdrucken des Haftvermittlers verhindert werden muß, daß dieser beim Aufdrucken ineinander fließt. Die Kleberbahnen müssen vielmehr einen genauen und scharf umgrenzten Verlauf aufweisen, um zu gewährleisten, daß die mit dem Kleber zu verbindende Metallschicht nur im Bereich der vorgesehenen Leiterbahnen auf der nicht leitenden Platte kleben. Andererseits müssen aber auch die Kleberbahnen so gleichmäßig auf die nicht leitende Platte aufgetragen werden, daß die Leiterbahnen von ihnen in gleichbleibender Stärke festgehalten werden. Die mit den Kleberbahnen verklebte Metallschicht muß so gleichmäßig mit der nicht leitenden Platte verklebt werden, daß beim Abziehen der Metallschicht die Kleberbahnen haften bleiben. Diese sorgfältige Anwendung des bereits vorbekannten Verfahrens
führt dazu, daß mit gut ausgewähltem Fachpersonal gearbeitet werden muß. Dieses Fachpersonal ist teuer, so daß trotz
der erheblichen Verbilligung, die das vorbekannte Verfahren für die Herstellung von gedruckten Schaltungen mit sich
gebracht hat, noch Rationalisierungsmöglichkeiten ausgeschöpft werden konnten. Insbesondere hat sich herausgestellt,
daß die angewendeten Druckverfahren sehr sorgfältig angewandt werden müssen.

Aufgabe der vorliegenden Erfingung ist es daher, den
Schichtstoff der einleitend genannten Art so zu verbessern,
daß auch bei schnellem Verfahrensablauf und beim Einsatz
vergleichsweise ungeübten Personals Feinleiter hergestellt
werden können, die den im Bereich der Feinleitertechnik zu
stellenden Anforderungen gerecht werden.

Diese Aufgabe wird erfindungsgemäß dadurch gelöst, daß mindestens eine der Schichten unter dem Einfluß von Strahlen
ein veränderliches Haftvermögen aufweist.

Der Verlauf der Leiterbahnen kann bei strahlungsempfindlichen
Schichten mit Hilfe von Strahlen festgelegt werden. Diese
Strahlen können sehr genau gelenkt und gebündelt werden, so
daß gestochen scharfe Linien entstehen. Je nach der Art der
mit Hilfe der Strahlen zu beeinflußenden Schicht kann eine
kurzwellige oder langwellige Strahlung Verwendung finden.
Auch bei engstem Verlauf von Feinleitern ist auf diese Weise
gewährleistet, daß unerwünschte Kontakte zwischen benachbarten Leiterbahnen nicht auftreten. Die gerade bei engem
Verlauf der Leiterbahnen notwendigen Toleranzen können durch
die Beeinflussung mit Hilfe von Strahlen eingehalten werden.

-3-

Die Heraustrennung der bestrahlten Teile von den unbestrahlten Teilen der strahlungsempfindlichen Schicht erfolgt exakt und gewährleistet , daß an den genau abgesteckten Grenzen keine unerwünschten Kontaktbrücken entstehen.

Die Festlegung derartig genau definierter Leiterbahnen ist mit bereits vorbekannten Verfahren nicht ohne weiteres gewährleistet. Um derartige Verfahren so durchführen zu können, daß die Leiterbahnen in engen Toleranzgrenzen genau verlaufen, müssen    die Grenzen der zu verstärkenden Leiterbahnen genau festgelegt werden können.

Weitere Aufgabe der vorliegenden Erfindung ist es daher, das Verfahren der einleitend genannten Art so zu verbessern, daß mit kleinem Durchführungsaufwand eine hohe Genauigkeit auch bei der Herstellung von Mikroleitern erreicht wird.

Diese Aufgabe wird erfindungsgemäß dadurch gelöst, daß mindestens eine der Schichten aus einem strahlungsempfindlichen Material hergestellt wird, daß nicht zu bestrahlende Teile der strahlungsempfindlichen Schicht mit einer die Leiterbahnen aufweisenden Schablone abgedeckt werden und die nicht abgedeckten Teile bestrahlt werden und daß die bestrahlten Teile der strahlungsempfindlichen Schicht von den unbestrahlten Teilen getrennt und dabei Teile der Metallschicht freigelegt werden, die in einem Metallisierungsbad verstärkt werden.

Durch dieses Verfahren können die Leiterbahnen sehr genau und schnell auf das nicht leitende Material aufgebracht werden. Dabei werden Fertigungsfehler mit hoher Sicherheit vermieden. Die Schablone wird einmalig hergestellt und unterliegt während ihres Gebrauchs kaum einem Verschleiß. Die Strahlen bilden sehr scharfe Grenzen in der strahlungsempfindlichen Schicht aus. Auf diese Weise liegen die Bahnen, entlang derer die zu verstärkende Metallschicht verläuft, innerhalb genauer Toleranzgrenzen fest. Auf diese Bahnen kann

- 4 -

Metall im Metallisierungsbad abgelagert werden, so daß durch relativ einfache Fertigungsschritte eine Leiterplatte hoher Präzision entsteht.

Das Verfahren ist daher besonders gut auch zur Herstellung von gedruckten Schaltungen im Bereich der Feinleitertechnik geeignet. Gerade bei der Herstellung von Mikroleitern müssen die Leiterbahnen genau abgegrenzt sein, um sie wie gewünscht auf einer Platte unterbringen zu können. Zu diesem Zwecke bedarf es sehr feiner Ausbildungen der Leiterbahnen, damit zwischen ihnen keine Kontaktbrücken entstehen. Diese genauen Linienführungen sind aufgrund der gestochen scharfen Strahlenführung möglich, mit der die zu verstärkenden Linien auf der Metallschicht vorgegeben werden.

Das Verfahren ist geeignet für die Herstellung großer Serien, da es weitgehend selbsttätig abläuft, ohne daß es menschlicher Einggriffe bedarf. Auf diese Weise wird auch die Fehlerquote ausgeschaltet, die aufgrund menschlichen Fehlverhaltens einkalkuliert werden muß.

Weitere Einzelheiten der Erfindung ergeben sich aus der nachfolgenden ausführlichen Beschreibung und den beigefügten Zeichnungen, in denen eine bevorzugte Ausführungsform der Erfindung beispielsweise veranschaulicht ist.

In den Zeichnungen zeigen:

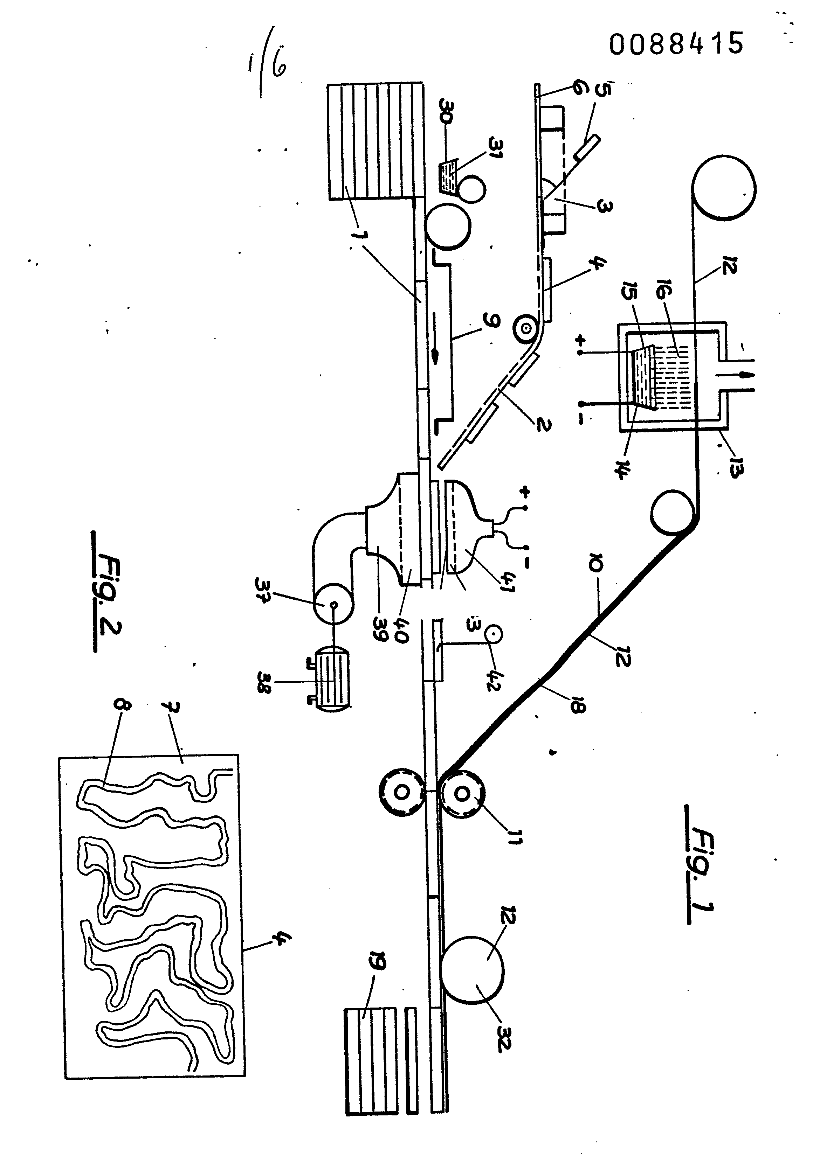

Fig.1: Eine schematische Darstellung einer Anlage zur Durchführung des erfindungsgemäßen Verfahrens,

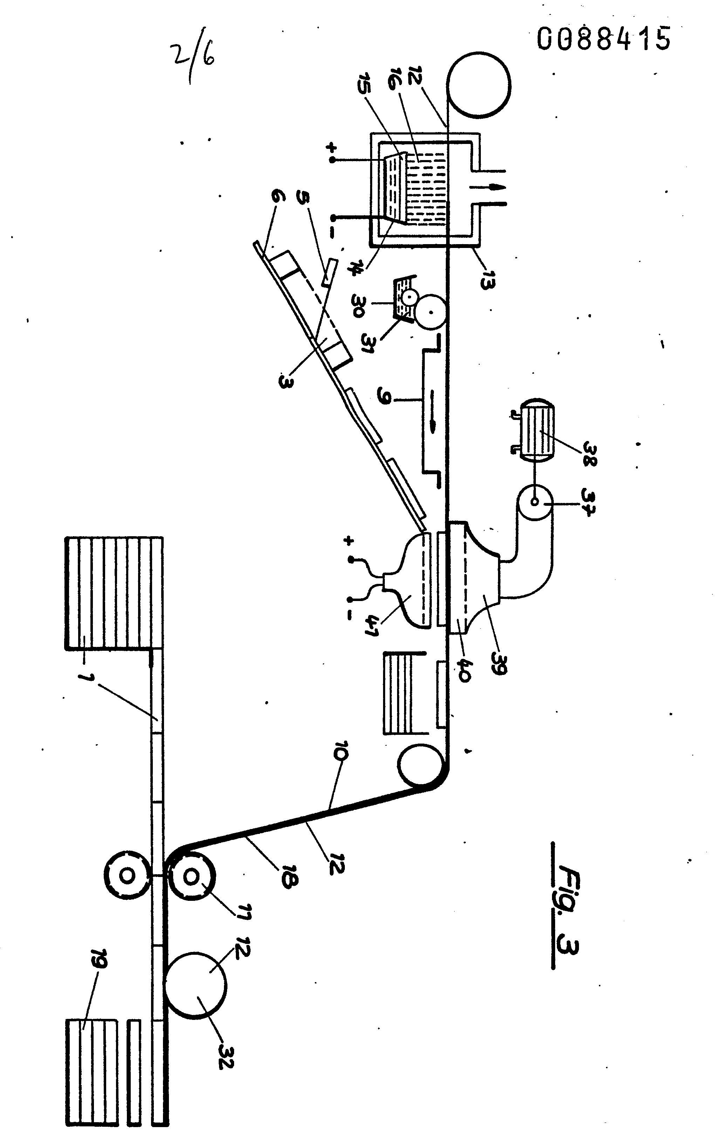

Fig.2: eine Draufsicht auf eine Schablone,

Fig.3: eine schematische Darstellung einer anderen Anlage, bei der der Kleber auf die Metallschicht aufgefahren wird,

Fig. 4 : eine schematische Darstellung einer Anlage, bei
der eine Lackschicht von der Metallbedampfung
belichtet wird,

Fig. 5: eine schematische Darstellung    einer Anlage,
bei der eine Belichtung der Lackschicht nach der
Herstellung eines Schichtstoffes vorgenommen wird,

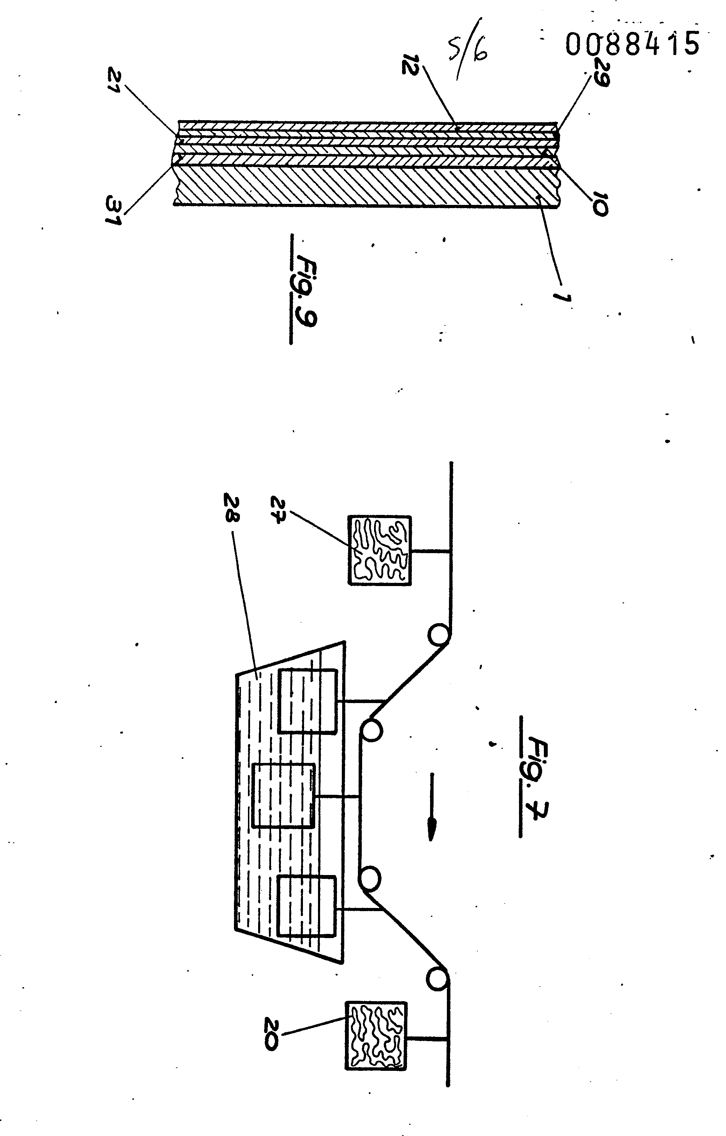

Fig. 6: eine schematische Darstellung eines Metallisierungsbades,

Fig. 7: eine schematische Darstellung eines Ablösebades,

Fig. 8: eine schematische Darstellung einer Anlage zur
Bestrahlung der Folie und

Fig. 9: eine Schnittzeichnung durch einen Schichtstoff.


Ein Schichtstoff besteht im wesentlichen aus einem nicht leitendem
Material 45, einer Kleberschicht 31, einer Metallschicht 10, einer
Lackschicht 21 und einer Folie 12. Auf der als Träger ausgebildeten
Folie 12 haftet die Metallschicht 10 über die Lackschicht 21 . Auf
die der Lackschicht 21 abgewandte Seite der Metallschicht 10 ist
die Kleberschicht 31 aufgetragen, auf der das Material 45 haftet.


Aus diesem Schichtstoff werden Leiterplatten hergestellt. Zu diesem
Zwecke werden auf die Metallschicht 10 Leiterbahnen 34 aufgetragen.
Diese Auftragung erfolgt in einem Metallisierungsbad 17, in dem
Metall von einem Metallvorrat 35 auf die Metallschicht 10 übertragen
wird. Die Übertragung erfolgt entlang vorgegebener Linien, die
dem beabsichtigten Verlauf von Leiterbahnen 34 entsprechen. Diese
Linien werden auf der Metallschicht 10 in der Weise festgelegt,
daß alle zwischen den Linien liegenden Bereiche 36 so abgedeckt
werden, daß sich auf ihnen kein Metall im Metallisierungsbad 17
ablagern kann. Es ist jedoch auch möglich, die zwischen den Linien
liegenden Bereiche 36 von dem Material 45 zu entfernen, so daß
lediglich die Linien zum Zwecke der Verstärkung im Metalli sierungs
bad 17 auf dem Material 45 haften. Die Auftragung des Metalls
kann stromlos in einem entsprechenden chemischen Bad oder galvanisch erfolgen.

Die Ausbildung der Linien geschieht mit Hilfe eines strahlungsempfindlichen Materials. Dieses wird je nach der Durchführung
des erfindungsgemäßen Verfahrens so bestrahlt, daß entweder ausschließlich die Linien auf dem Material 45 haften oder die übrigen
Bereiche 36 so weitgehend abgedeckt sind, daß lediglich die Linien
im Metallisierungsbad 17 metallisiert werden. Die Linien werden
entsprechend dem erfindungsgemäßen Verfahren ausgebildet. Dieses
erfindungsgemäße Verfahren wird in seinen drei folgenden Ausführungsformen beschrieben:

1. In einem Vorratsbehälter ist Material 45, insbesondere Platten
1 in einem Stapel untergebracht, auf das Leiterbahnen zum Zwecke
der Herstellung gedruckter Schaltungen aufgebracht werden sollen.
Statt Platten kann auch rollbares Material verwendet werden.

Das Material 45 wird auf seiner Oberfläche in einem Lackierwerk
30 mit einer Kleberschicht vollflächig beschichtet. Sodann wandert
das Material 45 in Richtung auf eine Trockenstation 9, in der
die Kleberschicht 31 getrocknet wird.

Parallel zu der Herstellung der Kleberschicht 31 auf dem Material
45 werden Schablonen 4 gezeichnet, gedruckt oder fototechnisch
hergestellt. Beispielsweise kann in einem Druckwerk 3 ein Schablonenmaterial 6 mit Abdeckbahnen 8 bedruckt werden, zwischen
denen Flächenteile 7 liegen. Der Verlauf der Abdeckbahnen 8 stimmt
mit denjenigen von Linien überein, die auf die Metallschicht 10
aufgetragen werden und die zu Leiterbahnen 34 im Metallisierungsbad verstärkt werden sollen.

Die Schablone 4 wandert über eine Förderbahn 2 in Richtung auf
eine Folie 12, die von einer Vorratsrolle 22 abgewickelt wird. Diese
Folie 12 ist in einem Lackierwerk 23 mit der Lackschicht 21 beschichtet worden. Diese Lackschicht 21 kann unmittelbar nach ihrem
Aufbringen auf die Folie 12 getrocknet werden. Es ist aber auch
möglich, bei einem schnell trocknenden Lack 24 die Folie 12 unmittelbar in den Bereich eines Strahlers 41 eintreten zu lassen. Dieser
Lack 24 ist strahlungsempfindlich. Unter dem Einfluß einer bestimmten Bestrahlung mit ultraviolettem Licht verändert er seine Eigenschaften in der Weise, daß er mehr oder minder fest auf der Folie
12 haftet.

Die Folie 12 wandert mit ihrer Lackschicht 21 unter den Strahler 41, der beispielsweise ultraviolettes Licht in Richtung auf die Lackschicht 21 aussendet. Im Strahlengang des Strahlers 41 liegt eine Schablone 4, die von der Förderbahn 2 in Richtung auf den Strahler 41 gefördert worden ist. Um eine genaue Lage der Schablone 4 bezüglich des Strahlers 41 zu gewährleisten, wird die Schablone 4 von einer Saugstation 4o gegen die Lackschicht 21 gesaugt, bevor der Strahler 41 angeschaltet wird. Dabei ist es denkbar, die Förderbahn 2 im Bereich der Saugstation 4o so zu führen, daß die Schablone 4 unmittelbar auf der Lackschicht 21 aufliegt. Es ist jedoch auch denkbar, die Schablone 4 unmittelbar vor dem Strahler 41 zu führen. Zu diesem Zwecke wird ein starker Unterdruckerzeuger 37 von einem Antrieb 38 angetrieben. Der vom Unterdruckerzeuger 37 erzeugte Unterdruck gelangt über einen Saugstutzen 39 in den Bereich der Saugstation 4o.

Die Folie 12 wandert mit der belichteten Lackschicht 21 in eine Bedampfungsstation 13, wo die Metallschicht 1o auf die Folie 12 aufgedampft wird. Zu diesem Zwecke ist in der Bedampfungsstation 13 eine Heizung 14 vorgesehen, die ein Metallbad 15 so hoch erhitzt, daß unter dem Einfluß eines in der Bedampfungsstation 13 herrschenden Vakuums Metalldampf 16 in Richtung auf die durch die Bedampfungsstation 13 hindurchlaufende Folie 12 aufsteigt und sich an dieser niederschlägt. Auf diese Weise wird eine Schichtstoffkombination 18 hergestellt, die in Richtung auf das mit der Kleberschicht versehene Material 1 gelenkt wird. Im Bereich einer Walzenkombination 11 wird die Schichtstoffkombination 18 auf die mit der Kleberschicht versehene Seite des Materials 45 geklebt. Je nach der Art des verwendeten Klebers 3o kann diese Walzenkombination beheizt sein.

Nach dem Verkleben der Schichtstoffkombination 18 mit dem Material 45 ist der Schichtstoff entstanden. Von diesem Schichtstoff kann die Folie 12 abgelöst werden. Beim

0088415

Ablösen haften diejenigen Teile der Lackschicht 21 an
der Folie 12, die beim Durchlaufen durch die Saugstation
4o von den Strahlen des Strahlers 41 getroffen worden sind.
Diese Teile verlaufen entlang der Linien, auf denen Metall
im Metallisierungsbad 17 abgelagert werden soll. Demgegenüber haftet im Bereich 36 die Lackschicht 21 zwischen den
Linien, so daß diese Bereiche im Metallisierungsbad nicht
metallisiert werden können. Das Abziehen der Folie 12 geschieht zweckmäßigerweise mit Hilfe einer Aufwickelrolle
32, auf die die vom Material 45 abgezogene Folie mit den
an ihr haftenden Teilen der Lackschicht 12 aufgewickelt
werden.

Nach dem Abziehen der Folie 12 liegen die Linien auf der
Oberfläche des Materials 45 frei, die im Metallisierungsbad 17 der Metallisierung ausgesetzt werden sollen. Auf
diese Weise sind aus dem Material 45 Rohlinge 19 entstanden,
die beispielsweise an einer Hängebahn 25 hängend durch
das Metallisierungsbad 17 geleitet werden können. In
diesem findet eine          Metallisierung der auf die
Oberfläche des Materials 45 aufgebrachten Metallschicht
statt. Diese Metallisierung kann beispielsweise auch in Form
einer elektrolytischen Galvanisierung vorgenommen werden.
Zu diesem Zwecke besteht das Metallisierungsbad 17 aus
einer elektrisch leitenden Flüssigkeit, in der Metallionen
von einem entsprechenden Metallvorrat 35 unter dem Einfluß
einer elektrischen Spannung 26 in Richtung auf die zu
metallisierende Metallschicht wandern und sich dort an den
Teilen der Rohlinge 19 niederschlagen, die mit der Metallschicht 1o versehen sind.

Die Durchtrittsgeschwindigkeit der Rohlinge 19 durch das
Metallisierungsbad 17 hängt ab von dem jeweils gewählten
Metall, der zwischen  dem Metallvorrat 35 und der Metallschicht 1o der Rohlinge 19 angelegten Spannung 26 sowie
der für das Metallisierungsbad 17 festgelegten Flüssigkeit. Nach dem Verlassen des Metallisierungsbades 17 ist
auf die mit der Metallschicht 1o versehenen Teile der Oberfläche des Materials 45 ein Metall abgelagert worden, das
die Leiterbahnen 34 bildet.

Auf diese Weise ist ein Zwischenprodukt 27 entstanden, das noch durch ein Lösungsbad 28 geleitet werden muß, um die zwischen den Leiterbahnen 34 vorhandene Metallschicht 10 und die auf ihr haftende Lackschicht 21 vom Material 45 abzulösen.

Diese Metallschicht 10 ist noch mit der Lackschicht 21 überzogen, die entweder vorher in einer nicht dargestellten Lösung abgelöst werden muß oder gleichzeitig mit der Metallschicht 10 im Lösungsbad 28 vom Material 45 abgelöst wird. Zu diesem Zwecke wird ein entsprechendes Lösungsbad 28 gewählt, das sowohl die Lackschicht 21 als auch die Metallschicht 10 angreift. Im Lösungsbad 28 wird auch von den aufgetragenen Leiterbahnen 34 ein Teil abgetragen, der sich nach der Länge der Zeit richtet, während sich das Zwischenprodukt 27 im Lösungsbad 28 befindet. Diese Abtragung der Leiterbahnen 34 ist aber berücksichtigt durch die Verstärkung , die im Metallisierungsbad 17 vorgenommen worden war. Auf diese Weise reicht der Querschnitt der Leiterbahnen 34 auch noch nach dem Verlassen des Lösungsbades 28 aus, um den durch die Leiterbahnen 34 hindurchzuleitenden Strom ohne Schwierigkeiten hindurchführen zu können. Auf diese Weise ist nach dem Verlassen des Lösungsbades 28 eine fertige Leiterplatte 20 entstanden.

Der Ablauf des erfindungsgemäßen Verfahrens kann dadurch wesentlich variiert werden, daß verschiedene strahlungsempfindliche Lacke Verwendung finden, die unter dem Einfluß der Strahlung unterschiedliche Verhaltensweisen aufweisen. Beispielsweise ist es denkbar, einen strahlungsempfindlichen Lack 24 zu verwenden, der unter dem Einfluß der Strahlung eine Haftkraft entfaltet. Diese Haftkraft kann ihn einerseits fest mit der Folie 12 und andererseits fest mit der Metallschicht 10 verbinden. Demgegenüber entfalten die unbestrahlten Teile der Lackschicht 21 jedenfalls auf der Metallschicht 10 keine Haftkraft. Auf diese Weise ist es möglich, diejenigen Bereiche 36, die zwischen den herzustellenden Leiterbahnen 34 liegen, so fest über die Lackschicht 21 mit der Folie 12 zu verbinden, daß mit dem Entfernen der Folie 12 von dem nicht leitenden Material 45

diejenigen Teile der Metallschicht 1o von dem nicht leitenden Material 45 mit entfernt werden, die im Bereich der
bestrahlten Lackschicht 21 fest mit der Folie 12 verbunden
sind. Zweckmäßigerweise werden aus diesem Grunde die im
Bereich 36 zwischen den herzustellenden Leiterbahnen
liegenden Teile der Metallschicht 1o von der Kleberschicht
31 abgezogen. Gleichzeitig lösen sich beim Abziehen der
Folie 12 auch die auf der Metallschicht 1o nicht haftenden
Teile der unbestrahlen Lackschicht 21. Die Linien, entlang
derer durch Verstärkung die Leiterbahnen 34 entstehen
sollen, liegen auf diese Weise frei, so daß nunmehr das
nicht leitendende Material 45 zum Zwecke der Verstärkung
der Linien in das Metallisierungsbad 17 eingebracht werden
können.

Darüber hinaus ist es auch möglich, eine im unbestrahlten
Zustand nicht haftende Lackschicht 21 auf die Folie 12 aufzutragen. Sodann wird die Bestrahlung der Lackschicht 21
vorgenommen mit dem Ziel, die Haftkraft der Lackschicht
21 im Bereich der auszubildenden Leiterbahnen 34 so auszulösen, daß die Lackschicht 21 auf der Folie 12 haftet. Im
Bereich 36 zwischen den Linien haftet demgegenüber die
Lackschicht 21 auf der Folie 12 nicht. Nunmehr kann die
Folie 12 von der Schichtstoffkombination 18 abgehoben
werden, so daß die Metallschicht 1o im Bereich der Linien,
die zu den Leiterbahnen 34 verstärkt werden müssen, zum
Zwecke der Verstärkung freiliegen. In diesem Zustand wird
das beschichtete Material 45 durch das Metallisierungsbad
17 geleitet, so daß sich auf den Linien die Leiterbahnen
34 aufbauen können. Anschließend wird das in dieser Weise
vorbehandelte Material 1 durch das Lösungsbad 28 geleitet,
so daß sowohl die Metallschicht 1o als auch die Lackschicht
21 im Bereich 36, der zwischen den Leiterbahnen 34 liegt,
vom Material 45 abgelöst wird.

Weiterhin ist es möglich einen im unbestrahlten Zustand
haftenden Lack 24 zum Abdecken der Metallschicht 1o zu verwenden. Die Haftkraft des strahlungsempfindlichen Lackes 24 wird durch die Strahlung aufgehoben, so daß die Lackschicht 21 auf der Metallschicht 1o nicht mehr haftet.
Diese Bestrahlung wird im Bereich der Linien vorgenommen,
auf die die Leiterbahnen 34 aufgebracht werden müssen.
Beim Abziehen der Folie 12 vom Material 45 löst sich die
Lackschicht 21 im Bereich der Linien mit der Folie 12 von
der Metallschicht 1o, so daß diese für die Auftragung der
Leiterbahnen 34 freiliegt. Nach dem Auftragen der Leiterbahnen 34 im Metallisierungsbad 17 wird sowohl die im
Bereich 36 zwischen den Linien liegende Metallschicht 1o
als auch die sie abdeckende Lackschicht 21 im Lösungsbad
28 abgelöst.

Darüber hinaus ist es auch denkbar, die Lackschicht 21 auf
ihrer von der Metallschicht 1o abgewandten Seite mit einer
zusätzlichen Trennlackschicht 29 zu versehen. Auf dieser
Trennlackschicht 29 haftet die Folie 12. Nach dem Entfernen
der Folie 12 mit der auf ihr haftenden Trennlackschicht
29 liegt die Lackschicht 21 frei. Diese kann nunmehr im
Bereich der Leiterbahnen 34 abgetragen werden. Zu diesem
Zwecke ist es möglich, eine im unbestrahlten Zustand nicht
haftende Lackschicht 21 zu verwenden, die im Bereich 36
zwischen den Linien bestrahlt wird. Durch die Bestrahlung
erhält die Lackschicht 21 ihre Haftkraft, die sie auf der
Metallschicht 1o festhält, während die unbestrahlte Lackschicht 21 im Bereich der Leiterbahnen 34 abgelöst werden
kann. Andererseits kann aber auch eine im unbestrahlten
Zustand haftende Lackschicht 21 Verwendung finden, die
durch die Bestrahlung ihre Haftkraft verliert. Diese
Bestrahlung erfolgt im Bereich der Leiterbahnen 34, so daß
die bestrahlte Lackschicht 21 im Bereich der Leiterbahnen
34 ausgewaschen werden kann. Nunmehr werden die Leiterbahnen 34 auf die freiliegende Metallschicht 1o aufgetragen
und im Bereich 36 zwischen den Leiterbahnen 34 sowohl die
Metallschicht als auch die sie abdeckende Lackschicht in
einem Lösungsbad 28 abgelöst.

2. Eine weitere Möglichkeit den Verlauf von Leiterbahnen 34 auf dem nicht leitenden Material 45 durch Strahlung genau festzulegen besteht darin, daß ein Haftvermittler als Kleberschicht 31 Verwendung findet, der strahlungsempfindlich ist. Dieser Kleber wird auf die Oberfläche des Materials 45 vollflächig mit Hilfe eines Lackierwerkes 3o aufgetragen. Sodann wandert das beschichtete Material 45 in Richtung auf eine Trockenstation 9, in der die Kleberschicht 31 getrocknet wird.

Unmittelbar hinter der Trockenstation 9 befindet sich die Saugstation 4o, mit deren Hilfe die über die Förderbahn 2 herantransportierten Schablonen 4 auf die getrocknete Kleberschicht 31 gesaugt werden. Sodann findet eine Belichtung der Kleberschicht mit Hilfe des Strahlers 41 statt. Unmittelbar hinter der Saugstation 4o wird die Schablone 4 von dem Material 45 beispielsweise mit Hilfe eines Hebezeuges 42 abgehoben. Das Material 45 wandert nunmehr unter die Walzenkombination 11, mit deren Hilfe die in der Bedampfungsstation 13 hergestellte Schichtstoffkombination 18 auf das Material 45 aufgetragen wird. Dabei verkleben lediglich diejenigen Teile der Kleberschicht 31 mit der Metallschicht 1o der Schichtstoffkombination 18, die durch die von der Walzenkombination 11 erzeugte Wärme reaktivierbar sind. Reaktivierbar sind aber nur diejenigen Teile der Kleberschicht 31, die von den Strahlen des Strahlers 41 nicht getroffen worden sind. Die Teile der Kleberschicht 31, die im Bereich 36 zwischen den Leiterbahnen 34 liegen, sind durch die Bestrahlung so weitgehend ausgehärtet, daß sie durch die Wärme der Walzenkombination 11 nicht reaktiviert werden können. In diesen Bereichen haftet die Metallschicht 1o auf der Kleberschicht 31 nicht.

Mit Hilfe der Aufwickelrolle 32 wird die Folie 12 von dem beschichteten Material 45 abgehoben. Dabei haftet die Metallschicht 1o im Bereich der aufzutragenden Leiterbahnen 34 fest auf der Oberfläche des Materials 45 Diese Haftung ist so fest, daß die Folie 12 von der

Metallschicht 1o abgehoben werden kann, ohne daß sich die Metallschicht 1o an den verklebten Stellen von dem Material 45 löst. Gleichzeitig wird die Metallschicht 1o in dem Bereich der Flächenteile 7, in denen sich eine reaktivierte Kleberschicht 31 nicht befindet, von der Oberfläche des Materials 45 abgehoben. Auf diese Weise entstehen Platten als Rohlinge 19, die im Bereich der zukünftigen Leiterbahnen 34 mit einer Metallschicht beklebt sind.

Diese Rohlinge werden nunmehr mit Leiterbahnen 34 versehen. Zu diesem Zwecke werden die Rohlinge 19 in das Metallisierungsbad 17 geleitet, in dem die Leiterbahnen 34 aufgetragen werden.

Es ist jedoch auch möglich, einen Haftvermittler zur Herstellung der Kleberschicht 31 zu verwenden, der unter dem Einfluß von Strahlen seine Klebkraft entfaltet. In diesen Fällen muß die Schablone 4 so hergestellt werden, daß die Bestrahlung lediglich im Bereich der Leiterbahnen 34 stattfindet. Durch die Bestrahlung wird im Bereich der Leiterbahnen 34 die Klebkraft der Kleberschicht 31 so weitgehend hergestellt, daß der Kleber unter den Walzen 11 durch Wärme aktiviert werden kann. Dadurch verklebt die Metallschicht 1o im Bereich der Leiterbahnen 34 mit dem Material 45 In den Bereichen 36, die zwischen den Leiterbahnen 34 liegen, findet eine Verklebung der Metallschicht 1o mit dem Material 45 nicht statt, so daß beim Aufwickeln der Folie 12 auf die Aufwickelrolle 32 die Metallschicht im Bereich 36 vom Material 45 abgehoben wird. Die auf diese Weise im Bereich der Leiterbahnen 34 stehengebliebene Metallschicht 1o wird im Metallisierungsbad 17 verstärkt, so daß die Leiterbahnen 34 entstehen.

Es ist jedoch auch möglich, die Kleberschicht 31 nicht auf das Material 45 sondern auf die Metallschicht 1o der

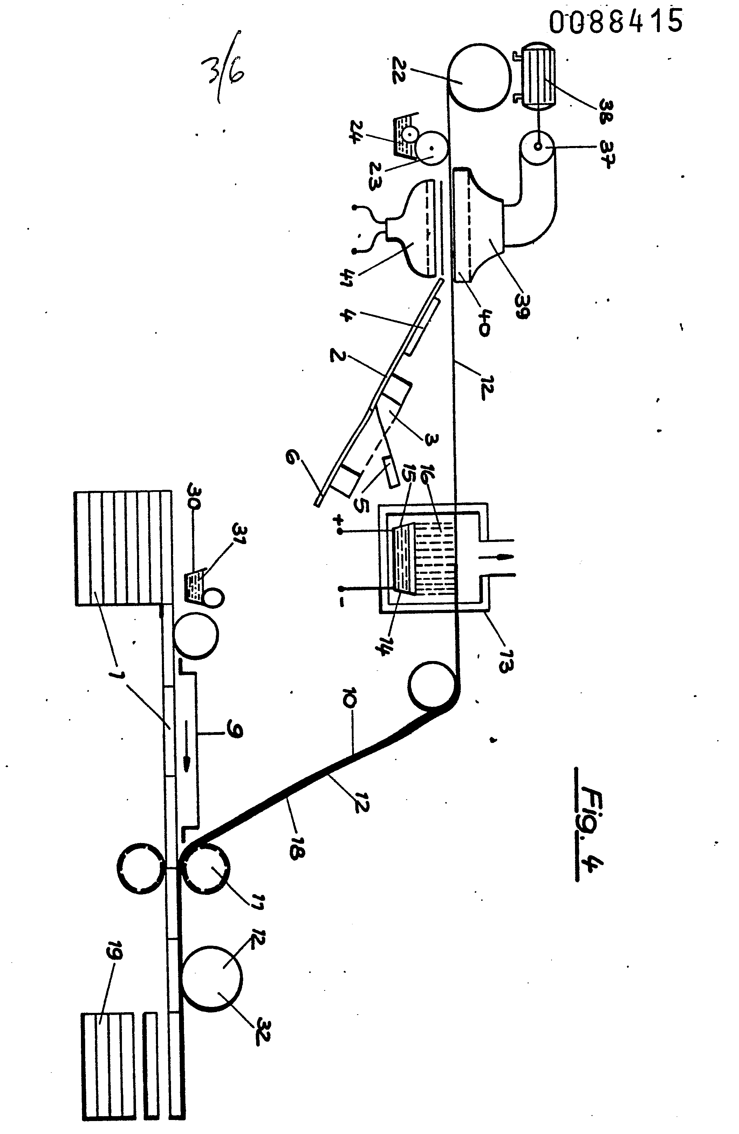

Schichtstoffkombination 18 aufzufahren. In diesem Falle
ist entsprechend Figur 3 diese Saugstation 40 unmittelbar hinter der Trockenstation 9 vorgesehen. Die auf die
Metallschicht 1o aufgefahrene Kleberschicht 31 wird mit
Hilfe des Strahlers 41 bestrahlt. Sodann werden die
reaktivierbaren Teile der Kleberschicht 31 in der Walzenkombination 11 mit dem Material 45 verklebt. Die Auftragung der Kleberschicht 31 auf die Metallschicht 1o hat
den Vorteil, daß die Kleberschicht 31 nicht in die
Metallschicht 1o eindringen kann, bevor sie reaktiviert
wird. Je nach der Qualität des Materials 45 ist es denkbar, daß die Kleberschicht 31 in die Oberfläche des
Materials 45 eindringt, so daß eine erhebliche Menge
Kleber auf das Material 45 aufgefahren werden muß, um
im Bereich der Walzenkombination 11 eine zum Verkleben
der Metallschicht 1o ausreichende Kleberschicht 31 zur
Verfügung zu haben.


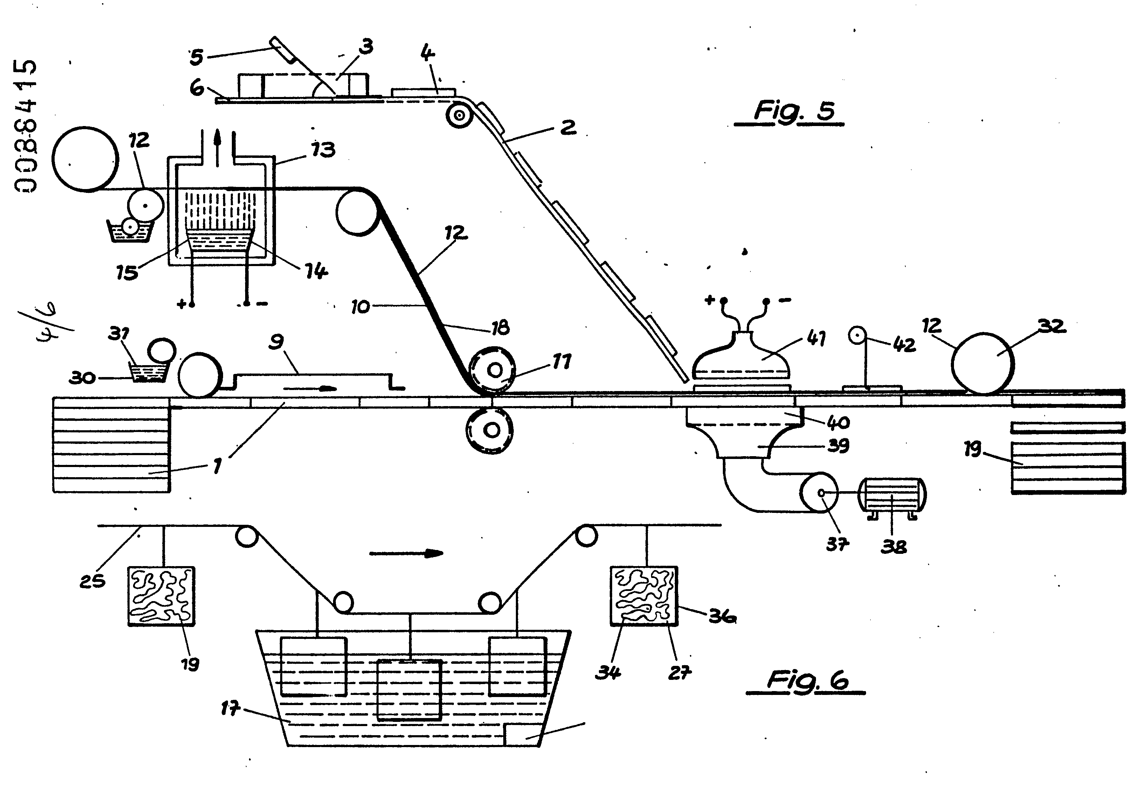

Die Bestrahlung erfolgt jeweils in einem Zustand der
zu bestrahlenden Schicht, in dem diese die gewünschten
Veränderungen unter dem Einfluß der Strahlung erfährt.
So ist es denkbar, daß einige Kleber im feuchten, andere
im getrockneten Zustand bestrahlt werden. In ähnlicher
Weise werden auch die Lackschichten 21 je nach dem aufgetragenen Lack entweder im trockenen oder im feuchten
Zustand bestrahlt. Darüber hinaus ist es möglich, die
Lackschichten 21 zu bestrahlen, nach dem sie auf die
Folie 12 aufgetragen worden sind. Es ist jedoch auch
denkbar, die Bestrahlung der Lackschicht 21 erst dann
vorzunehmen, wenn die Schichtstoffkombination 18 bereits
mit dem Material 45 verklebt worden ist. In diesem Falle
wird die Lackschicht 21 durch die Folie 12 hindurch bestrahlt, wie es in der Figur 5 gezeigt ist.


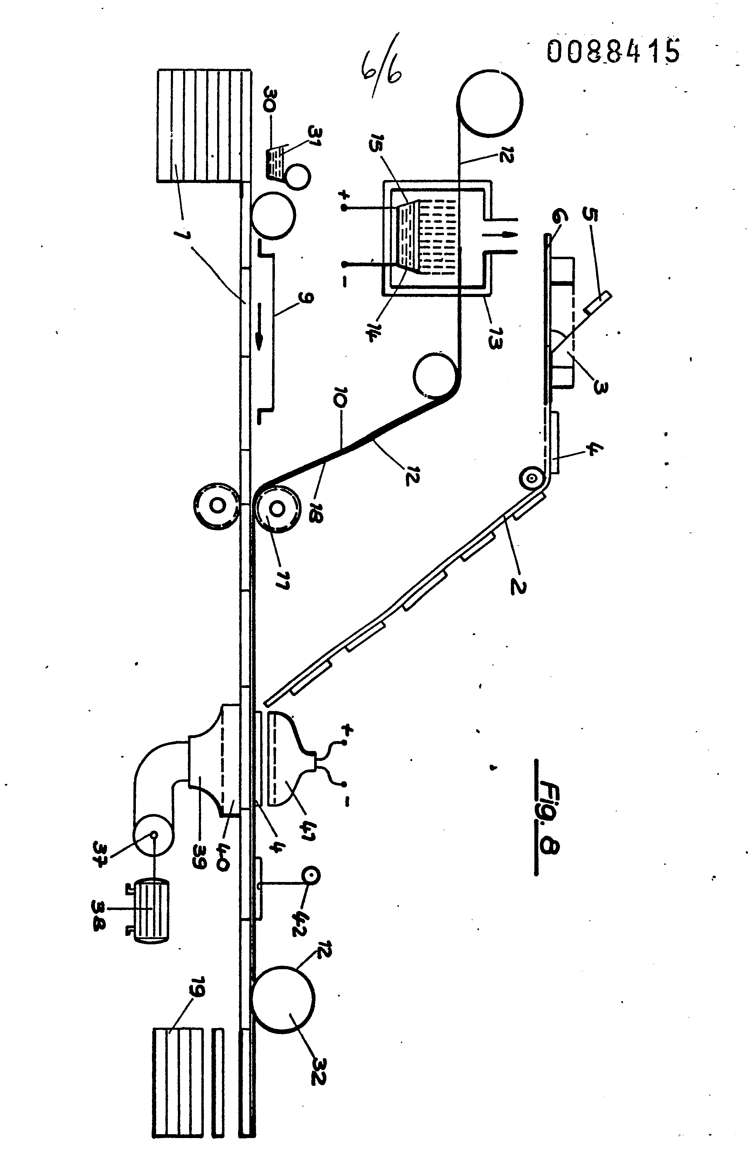

3. Schließlich kann das erfindungsgemäße Verfahren auch
noch in der Weise durchgeführt werden, daß eine strahlungsempfindliche Folie 12 Verwendung findet. Auf diese wird entsprechend Figur 8 die Metallschicht 1o im
Bereich einer Bedampfungsstation 13 aufgetragen. Nunmehr
wird mit der auf diese Weise hergestellten Schichtstoffkombination 18 das Material 45 im Bereich der Walzenkombination 11 verklebt. Dabei kann die Kleberschicht 31
entweder auf das Material 45 oder auf die Metallschicht
1o der Schichtstoffkombination 18 aufgetragen werden.

Nach dem vollflächigen Verkleben der Schichtstoffkombination 18 mit dem Material 45 wird die Folie 12 bestrahlt.
Zu diesem Zwecke wandert das beschichtete Material 45
durch die Saugstation 4o, in der eine Schablone 4 auf
die Folie 12 gesaugt wird. Durch die Bestrahlung wird
die Folie 12 in ihren Eigenschaften so weitgehend verändert, daß sie ihre Haftung gegenüber der Metallschicht
1o verliert. Zu diesem Zwecke wird die Folie durch die
Schablone 4 hindurch im Bereich der Leiterbahnen 34 bestrahlt. Nachdem die Schablone vom Hebezeug 42 unmittelbar hinter dem Strahler 41 von dem beschichteten Material 45 abgehoben worden ist, wird der nicht haftende
Teil der Folie 12 von dem Material 45 mit Hilfe der Aufwickelrolle 32 abgehoben. Im Bereich 36 zwischen den
aufzutragenden Leiterbahnen 34 haftet demgegenüber die
Folie 12. Die auf diese Weise vorbereiteten Rohlinge
19 können in ein Metallisierungsbad 17 eingeleitet und
die Leiterbahnen 34 aufgetragen werden. Anschließend
wandert das auf diese Weise entstandene Zwischenprodukt
27 durch das Lösungsbad 28, in dem sowohl die Metallschicht 1o als auch die sie abdeckende Folie 12 von
dem Material 45 abgelöst wird.

Eine für die Fertigung besonders günstige Art des Verfahrens besteht darin, daß die Schablone 4 unmittelbar auf die strahlungsempfingliche Folie 12 aufgedruckt wird. Zu diesem Zwecke wird auf die strahlungsempfindliche Folie 12 eine die jeweiligen Strahlen nicht durchlassende Schicht gedruckt. Das Aufdrucken dieser Schicht kann entweder erfolgen, wenn die Folie bereits mit der Metallschicht versehen ist oder vor dem Aufbringen der Metallschicht. Das Bedrucken der Folie vor dem Aufdampfen der Metallschicht hat den Vorteil, daß die Folie vor dem Bedampfen über eine Druckwalze laufen kann , mit deren Hilfe die Folie während des Durchlaufs fortlaufend bedruckt wird.

Der Strahler 41 kann alle denkbaren Strahlen aussenden, die geeignet sind, um entweder auf die Kleberschicht 31 oder die Lackschicht 21 oder die Folie 12 den gewünschten Einfluß nehmen zu können. So ist es beispielsweise denkbar, ultraviolettes oder infrarotes Licht zu verwenden. Darüber hinaus sind auch andere Strahlen, wie beispielsweise Alfa- und Gamma-Strahlen
verwendbar. Außerdem ist es denkbar, die Schicht
einer Neutronen- bzw. Elektronenbestrahlung auszusetzen.
Am nächstliegenden ist jedoch die Verwendung einer fotoempfindlichen Schicht, die lediglich unter dem Einfluß
des Tageslichts die gewünschten Veränderungen durchführt.

Die beschriebenen Verfahren sind in ihrer Wirkungsweise
unabhängig von den verwendeten Materialien 45, von den
Metallen für die Metallschicht 1o, von den verwendeten
Klebern für die Kleberschicht 31 sowie von den verwendeten Lacken 24. Sie sind auch unabhängig von dem Einsatz verschiedener Metallisierungsbäder 17.

Die Schablonen 4 können auch in anderer Weise als durch
Unterdruck im Bereich des Strahlers 41 über der
zu bestrahlenden Schicht gehalten werden. Dabei ist es
beispielsweise denkbar, die Schablonen 4 auf einer gesonderten Bahn, die zwischen dem Strahler 41 und der
Oberfläche des Materials 45 verläuft, zu führen. Entscheidend kommt es bei einer derartigen Führung der
Schablone 4 zwischen dem Strahler 41 und der Oberfläche
des Materials 45 darauf an, daß ein scharfes Bild der
Abdeckbahnen 8 auf der jeweils durch die Belichtung zu
beeinflussenden Schicht erzeugt wird. Bei einem stark
gebündelten Licht kann aber die Brechung des Lichts,
die an den Kanten der Abdeckbahnen 8 hervorgerufen
wird, genügend genau einkalkuliert werden. Schließlich ist es auch denkbar, die Schablonen 4 in Führungen
43 zu haltern, die am Strahler 41 vorgesehen sind.
Diese Führungen 43 sorgen dafür, daß die einzelnen
Schablonen 4 unmittelbar auf der dem Material 45 zugewandten Austrittsfläche 44 der Strahlen geführt werden.

Das erfindungsgemäße Verfahren kann beispielsweise wie folgt ablaufen:

1. Auf eine Folie 12 aus Polypropylen wird in einem Lackierwerk
23 eine Lackschicht 21 aus einem Polyurethan – Acrylat aufgebracht.
Dieser Lack härtet unter dem Einfluß von Lichtstrahlen aus, die
vom Strahler 41 in Richtung auf die Lackschicht 21 ausgesendet
werden. Diese belichtete Lackschicht 21 wird in einer Bedampfungsstation 13 mit einer Kupferschicht bedampft. In der Bedampfungsstation 13 herrscht ein Unterdruck von $10^{-4}$ Torr und eine Temperatur von 1050 °C . Sodann wird auf die Kupferschicht ein Haftvermittler aufgebracht, der einem reaktiven Harzsystem angehört.
In Betracht kommen als Epoxydharze ausgebildete Kleber. Mit diesem
Kleber ist als Material 45 ein Epoxitgewebe verbunden. Von dem
auf diese Weise entstandenen Schichtstoff wird die Folie 12 abgelöst.
An ihr haften die ausgehärteten Teile des Polyurethan-Acrylats.
Sodann wird die Aufkupferung der freigelegten Metallschicht in
einem Bad für die stromlose Verkupferung vorgenommen. Dieses
Bad besteht aus 3,6 g/l $CuSO_4$ , 3,75 g/l NaOH , 25,00 g/l

$NaKC_4H_4O_6 \times 4 H_2O$ und 10 ml $H_2CO$ (35%). Die Verkupferung

findet bei einer Badtemperatur von 21 bis 24°C statt. Nach der
Aufbringung der Kupferbahnen wird die zwischen den Kupferbahnen
liegende Metallschicht sowie die sie abdeckende Lackschicht mit
einer Ätzlösung beseitigt, die wie folgt zusammengesetzt ist:

1 l Wasser, 500 g Eisen-3-chlorid , 20 ml Salzsäure (30%). Dieses
Bad befindet sich auf einer Ätztemperatur von 50°C.


2. Auf eine Polyester-Folie wird ein Trennlack aufgefahren. Als
Trennlack kommt ein Salz der Acrylsäure in Betracht. Auf diese
Trennlackschicht wird eine Kupferschicht aufgedampft. Für das
Aufdampfen werden in der Bedampfungsstation die gleichen Bedingung wie im vorigen Beispiel hergestellt. Auf ein Material 45
z. B.

Phenolharzpapier wird eine U-V-lichtempfindliche Klebstoffschicht aus einem Polyurethan-Acrylat aufgebracht. Nach Auflegen einer Schablone wird diese Kleberschicht mit U-V-Licht belichtet. Sodann wird die Kleberschicht mit der aufgedampften Metallschicht verklebt. Dabei erfolgt lediglich eine Klebverbindung im Bereich der unbelichteten Klebstoffstellen. Sodann wird die Folie mit der auf ihr anhaftenden Metallschicht von den unverklebten Teilen des Materials 45 abgezogen, während sich die Trennlackschicht an den mit dem Material 45 verklebten Teilen der Metallschicht von dieser löst. Die auf diese Weise freigelegten Teile der Metallschicht können in einem galvanischen Kupferbad aufgekupfert werden. Dieses Kupferbad besteht aus einer Mischung , bei der auf einen Liter destilliertes Wasser 250 g Kupfersulfat und 70 chemisch reine Schwefelsäure kommen.

3. Eine Folie aus Polyvenylalkohol wird mit Bromdioxyd präpariert. Auf diese Folie wird eine Schablone aufgedruckt, die den herzustellenden Leiterbahnen entspricht. Die mit der Schablone bedruckte Folie wird auf ihrer dem Aufdruck abgewandten Seite mit einer Kupferschicht bedampft. Dabei herrschen in der Bedampfungsstation die im Beispiel 1 genannten Temperaturen und Unterdrücke. Sodann wird auf die Metallschicht über einen Haftvermittler, der aus einem Epoxidharz bestehen kann, das Material 45 aufgeklebt. Dabei kann es sich bei dem Material 45 um ein Polysulfon handeln. Sodann wird dieser Schichtstoff auf seiner der bedruckten Folie zugewandten Seite belichtet. Als Strahlenquelle kommt Tageslicht in Betracht. Durch das Belichten härtet die Folie aus und kann von der Metallschicht abgezogen werden. Nach dem Abziehen der Folie können die von der Folie freigelegten Teile der Kupferschicht aufgekupfert werden. Beim Aufkupfern steht das bereits beschriebene Bad für die stromlose Verkupferung zur Verfügung. Nach der Aufkupferung wird in der bereits beschriebenen Ätzlösung aus Wasser, Eisen-3-chlorid und Salzsäure der restliche Teil der Folie und die unter dieser Folie liegenden Teile der Kupferschicht abgeätzt, so daß lediglich die Kupferbahnen als Leiterbahnen bestehen bleiben.

# DIPL.-ING. DR. GERT HELDT
### Rechtsanwalt, Patentanwalt

Dr. Gert Heldt - Neuer Wall 57 IV. - 2000 Hamburg 36

Neuer Wall 57 IV. - 2000 Hamburg 36
Ruf 040 / 37 15 77 + 37 17 49

Sprechstunden nach Vereinbarung

Telegramme: Patentheldt, Hamburg

Helmuth Schmoock

Büchener Weg 121

2o58 Lauenburg/Elbe

Aktenzeichen: SH 21.

### Schichtstoff und Verfahren zur Herstellung
### von Leiterbahnen

Patentansprüche:

1.    Schichtstoff zur Herstellung von Leiterbahnen, der aus mindestens vier Schichten besteht, von denen eine eine Metallschicht ist, auf der die Leiterbahnen aufgebaut werden, von denen eine andere eine nicht leitende Platte ist, auf der die Metallschicht einerseits über einen eine weitere Schicht bildenden Haftvermittler haftet und deren letzte eine die Metallschicht andererseits abdeckende Folie ist, dadurch gekennzeichnet, daß mindestens eine der Schichten unter dem Einfluß von Strahlen ein veränderliches Haftvermögen aufweist.

2.    Schichtstoff nach Anspruch 1, dadurch gekennzeichnet, daß die Folie (12) auf der Metallschicht (1o) über

mindestens eine Lackschicht (21) haftet, die unter dem
Einfluß von Strahlen veränderbar ist.

3.    Schichtstoff nach Anspruch 1 und 2, dadurch gekennzeichnet, daß die strahlenempfindliche Schicht eine
Empfindlichkeit für langwellige Strahlung aufweist.

4.    Schichtstoff nach Anspruch 1 und 2, dadurch gekennzeichnet, daß die strahlenempfindliche Schicht eine
Empfindlichkeit für kurzwellige Strahlungen aufweist.

5.    Schichtstoff nach Anspruch 1 bis 4, dadurch gekennzeichnet, daß zwei Lackschichten (21,29) zwischen
der Metallschicht (1o) und der Folie (12) angeordnet
sind, von denen die eine eine Trennlackschicht (29)
ist  und der Folie (12) benachbart ist, auf der sie
fest haftet, und die andere strahlenempfindlich ist
und auf der Metallschicht (1o) haftet.

6.    Schichtstoff nach Anspruch 1 bis 5, dadurch gekennzeichnet, daß die strahlenempfindliche Lackschicht
(21) eine unter dem Einfluß von Strahlen abnehmende
Haftfähigkeit aufweist.

7.    Schichtstoff nach Anspruch 1 bis 6, dadurch gekennzeichnet, daß die strahlenempfindliche Lackschicht
(21) eine unter dem Einfluß von Strahlen abnehmende
Vernetzung aufweist.

8.    Schichtstoff nach Anspruch 1 bis 7, dadurch gekennzeichnet, daß die auf der Metallschicht (1o)
haftende Lackschicht (21) in einem Lösungsbad (28)
ablösbar ist.

9.    Schichtstoff nach Anspruch 1 bis 8, dadurch gekennzeichnet, daß der Haftvermittler    eine Kleberschicht (31) bildet, die unter dem Einfluß von Strahlen
eine abnehmende Haftvermittlung aufweist.

1o. Schichtstoff nach Anspruch 1 bis 8, dadurch gekennzeichnet, daß die Kleberschicht (31) unter dem Einfluß von Strahlen eine zunehmende Haftvermittlung aufweist.

11. Schichtstoff nach Anspruch 1 bis 1o, dadurch gekennzeichnet, daß die Folie (12) unter dem Einfluß
von Strahlen eine zunehmende Haftung auf der ihr benachbarten Schicht aufweist.

12. Schichtstoff nach Anspruch 1 bis 1o, dadurch gekennzeichnet, daß die Folie (12) unter dém Einfluß von
Strahlen eine abnehmende Haftung auf der ihr benachbarten Schicht aufweist.

13. Schichtstoff nach Anspruch 1 bis 12, dadurch gekennzeichnet, daß die Folie (12) im Lösungsbad (28)
von der ihr benachbarten Schicht ablösbar ist.

14. Verfahren zur Herstellung von Leiterbahnen auf
nicht leitenden Platten, gemäß Ansprüchen 1 bis 13,
aus einem Schichtstoff, der aus mindestens vier
Schichten besteht, von denen eine eine Metallschicht
ist, auf der die Leiterbahnen aufgebaut werden, von
denen eine andere eine nicht leitende Platte ist, auf
der die Metallschicht einerseits über einen eine
weitere Schicht bildenden Haftvermittler haftet, und
deren letzte eine die Metallschicht andererseits abdeckende Folie ist, dadurch gekennzeichnet, daß mindestens eine der Schichten aus einem strahlungsempfindlichen Material hergestellt wird, daß nicht zu bestrahlende Teile der strahlungsempfindlichen Schicht mit
einer die Leiterbahnen (34) aufweisenden Schablone (4)
abgedeckt werden und die nicht abgedeckten Teile bestrahlt werden und daß die bestrahlten Teile der strah-

- 4 -

lungsempfindlichen Schicht von den unbestrahlten Teilen
getrennt und dabei Teile der Metallschicht (1o) freigelegt werden, die in einem Metallisierungsbad (17) verstärkt werden.

15. Verfahren nach Anspruch 14, dadurch gekennzeichnet, daß die Metallschicht (1o) mit der Folie (12) über
mindestens eine strahlungsempfindliche Lackschicht (21)
verbunden wird.

16. Verfahren nach Anspruch 14 und 15, dadurch gekennzeichnet, daß auf die Folie (12) eine Trennlackschicht
(29) und auf diese eine strahlungsempfindliche Lackschicht (21) aufgetragen wird.

17. Verfahren nach Anspruch 14 bis 16, dadurch gekennzeichnet, daß eine im unbestrahlten Zustand nicht haftende Lackschicht (21) auf die Folie (12) aufgetragen
wird, daß die Haftkraft der Lackschicht (21) auf der
Metallschicht (1o) einerseits und der Folie (12) andererseits durch die Strahlung im zwischen den Leiterbahnen (34) liegenden Bereich ausgelöst wird, und die
Folie (12) mit den über die Lackschicht (21) an ihr
haftenden Teilen der Metallschicht (1o) von dem nicht
leitenden Material (1) und den auf der Metallschicht
(1o) nicht haftenden Teilen der Lackschicht (21) von
der Metallschicht (1o) abgelöst wird.

18. Verfahren nach Anspruch 14 bis 16, dadurch gekennzeichnet, daß eine im unbestrahlten Zustand nicht
haftende Lackschicht (21) auf die Folie (12) aufgetragen wird, daß die Haftkraft der Lackschicht (21) auf
der Folie (12) durch die Strahlung im Bereich der
Leiterbahnen (34) ausgelöst wird und die Lackschicht
(21) im Bereich ihrer Haftung an der Folie (12) von
der Metallschicht (1o) abgelöst wird, die Metallschicht
(1o) im Bereich der abgelösten Lackschicht (21) ver-

0088415

stärkt und anschließend die Lackschicht (21) und die
Metallschicht (1o) im zwischen den Leiterbahnen (34)
liegenden Bereich (36) abgelöst wird.

19. Verfahren nach Anspruch 14 bis 16, dadurch gekennzeichnet, daß eine im unbestrahlten Zustand haftende
Lackschicht (21) auf die Folie (12) aufgetragen wird,
daß die Haftkraft der strahlungsempfindlichen Lackschicht (21) auf der Metallschicht (1o) durch die
Strahlung im Bereich der Leiterbahnen (34) aufgehoben
wird und die auf der Metallschicht (1o) nicht haftende
Lackschicht (21) zusammen mit der Folie (12) von der
Metallschicht (1o) abgelöst wird und die freigelegte
Metallschicht (1o) im Bereich der Leiterbahnen (34)
verstärkt und anschließend die Lackschicht (21) und
die Metallschicht (1o) im Bereich (36) zwischen den
Leiterbahnen (34) abgelöst werden.

2o. Verfahren nach Anspruch 14 bis 16, dadurch gekennzeichnet, daß die Folie (12) von der Lackschicht (21)
getrennt wird und bestrahlte Teile der strahlungempfindlichen Lackschicht (21) von den unbestrahlten Teilen
in einem Lösungsbad (28) getrennt werden.

21. Verfahren nach Anspruch 2o, dadurch gekennzeichnet, daß die bestrahlten Teile von der Metallschicht
(1o) abgelöst werden.

22. Verfahren nach Anspruch 2o, dadurch gekennzeichnet, daß die unbestrahlten Teile von der Metallschicht
(1o) abgelöst werden.

23. Verfahren nach Anspruch 14 bis 22, dadurch gekennzeichnet, daß die Lackschicht (21) durch die Folie (12)
bestrahlt wird.

0088415

24. Verfahren nach Anspruch 14 bis 22, dadurch gekennzeichnet, daß die Lackschicht (21) vor der Aufbringung der Folie (12) bestrahlt wird.

25. Verfahren nach Anspruch 14, dadurch gekennzeichnet, daß die Metallschicht (1o) mit dem nicht leitenden Material (1) über einen strahlungsempfindlichen Haftvermittler verbunden wird.

26. Verfahren nach Anspruch 14 bis 25, dadurch gekennzeichnet, daß ein im unbestrahlten Zustand nicht haftender Haftvermittler auf die Metallschicht (1o) aufgetragen wird, daß die Haftkraft des Haftvermittlers durch die Strahlung im Bereich der Leiterbahnen (34) ausgelöst wird und der auf dem nicht leitenden Material (1) nicht haftende Haftvermittler mit den ihm entsprechenden Teilen der Metallschicht (1o) von dem nicht leitenden Material (1) entfernt werden.

27. Verfahren nach Anspruch 14 und 25, dadurch gekennzeichnet, daß ein im bestrahlten Zustand nicht haftender Haftvermittler auf die Metallschicht (1o) aufgetragen wird, daß die Haftkraft des Haftvermittlers durch die Strahlung im zwischen den Leiterbahnen (34) liegenden Bereich (36) aufgehoben wird und der auf dem nicht leitenden Material (1) nicht haftende Haftvermittler mit den ihm entsprechenden Teilen der Metallschicht (1o) von dem nicht leitenden Material (1) entfernt werden.

28. Verfahren nach Anspruch 14, dadurch gekennzeichnet, daß eine strahlungsempfindliche Folie (12) im Bereich der Leiterbahnen (34) bestrahlt wird, dadurch ihre Adhäsion auf der Metallschicht (1o) aufgehoben und anschließend von der Metallschicht (1o) entfernt wird.

29. Verfahren nach Anspruch 14, dadurch gekennzeichnet, daß eine strahlungsempfindliche Folie (12) im zwischen den Leiterbahnen liegenden Bereich (36) bestrahlt wird, dadurch ihre Adhäsion auf der Metallschicht (10) verstärkt und anschließend im Bereich der Leiterbahnen (34) von der Metallschicht (10) entfernt wird.

30. Verfahren nach Anspruch 28 und 29, dadurch gekennzeichnet, daß die strahlungsempfindliche Folie (12) mit einer für Strahlung undurchlässigen Schablone bedruckt ist.

Fig. 2

Fig. 1

1/6

00 88415

0088415

Fig. 3

Fig. 4

0088415

4/6

Fig. 5

Fig. 6

Fig. 9

Fig. 7

0088415

Fig.8